# EUROPEAN PATENT APPLICATION

(11) **EP 4 120 336 A1**
(43) Date of publication of application: **18.01.2023**
(21) Application number: 21185913.7
(22) Date of filing: 15.07.2021
(51) Int. Cl.: H01L 23/24, H01L 23/31, H01L 21/56

(54) **A SEMICONDUCTOR POWER MODULE WITH TWO DIFFERENT POTTING MATERIALS AND A METHOD FOR FABRICATING THE SAME**

(71) Applicant: Infineon Technologies Austria AG, 9500 Villach (AT)
(72) Inventor: HARTUNG, Hans, 59581 Warstein (DE); FUERGUT, Edward, 86453 Dasing (DE); MAYER, Martin, 93152 Nittendorf (DE)
(74) Representative: Lambsdorff & Lange Patentanwälte Partnerschaft mbB

(57) **Abstract**

A semiconductor power module (10) comprises an insulating interposer (1) comprising an insulative layer (1A) disposed between a lower metal layer, a first upper metal layer (1B) and a second upper metal layer (1C), a semiconductor transistor die (2) disposed on the first upper metal layer (1B), an electrical connector (3) connecting the semiconductor transistor die (2) with the second upper metal layer (1C), a housing (4) enclosing the insulating interposer (1) and the semiconductor transistor die (2), a first potting material (5) covering at least selective portions of the semiconductor transistor die (2) and the electrical connector (3); and a second potting material (6) applied onto the first potting material (5), wherein the first and second potting materials (5, 6) are different from each other.

## Description

### TECHNICAL FIELD

The present disclosure is related to a semiconductor power module and a method for fabricating the same.

### BACKGROUND

In semiconductor packages, heat may be generated by the semiconductor die. For high power semiconductor packages, the heat generated by a semiconductor die or chip may be very high, thus requiring the heat to be efficiently dissipated out of the semiconductor package into the environment. For dissipating the excessive heat either single side cooling in the form of bottom side cooling or top side cooling or dual side cooling can be employed which includes both bottom and top side cooling. All these variants include a vertical heat flow from the semiconductor die to one or more heatsinks applied to the semiconductor package.

Semiconductor power modules for high voltage applications up to 6500 V and high currents up to 2000 A and more are based on semiconductor devices like IGBT, diodes or other semiconductor devices (e.g. SiC MOSFET, GaN or GaAs semiconductors) mounted on ceramic substrates using metal wire bonds and/or power terminals to control the semiconductor device in customer application. The module assembly uses a plastic housing connected to the substrate if the module has no base plate or more than one substrate mounted on a baseplate. The electrical insulation is ensured by the ceramic of the substrate and a potting material mostly based on silicone gel or other organic material like epoxy resin or acrylate.

During operation of a power module different components (wire bonds, power terminals) can be heated up to 200°C so that this temperature level is also applied to the potting material. The potting material has a limitation to certain level of temperature application because polymers can degrade very fast if the application uses 200°C and more with resulting in a higher weight loss effect, reduction of elongation at break and increased hardness by oxidation effects which causes crack formation in the potting material with the higher risk of electrical insulation failure.

Special additives like heat stabilizers can be applied in the potting material to reduce the aging effect but in general at 200°C the degradation effect is strong enough to reduce the insulation property in the power module during the customer application.

The operation temperature for the first generation of IGBT semiconductor power devices has been specified with 125°C some decades ago and increases now from one chip generation to the next so that the recent technology uses 175°C operation and 200°C will be applied soon. The power terminals and wire bonds heat up about 25°C higher than the semiconductor operation temperature so that for 175°C at the chip the wire bonds are at 200°C operation level and with 200°C at the chip the wire bonds will be close to 225°C which is not capable by the potting material.

For these and other reasons there is a need for the present disclosure.

### SUMMARY

A first aspect of the present disclosure is related to a semiconductor power module, comprising an insulating interposer comprising an insulative layer disposed between a lower metal layer, a first upper metal layer and a second upper metal layer, a semiconductor transistor die disposed on the first upper metal layer, an electrical connector connecting the semiconductor transistor die with the second upper metal layer, a plastic housing enclosing the insulating interposer and the semiconductor transistor die, a first potting material covering at least selective portions of the semiconductor transistor die and the electrical connector, and a second potting material applied onto the first potting material, wherein the first and second potting materials are different from each other.

A second aspect of the present disclosure is related to a method for fabricating a semiconductor power module, the method comprising providing an insulating interposer comprising an insulative layer disposed between a lower metal layer, a first upper metal layer and a second upper metal layer, disposing a semiconductor transistor die on the first upper metal layer, connecting the semiconductor transistor die with an electrical connector with the second upper metal layer, enclosing the insulating interposer and the semiconductor transistor die with a plastic housing, covering selective portions of the semiconductor transistor die and the electrical connector with a first potting material and applying a second potting material onto the first potting material, wherein the first and second potting materials are different from each other.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows an example of a semiconductor power module according to the first aspect in a cross-sectional side view.
Fig. 2 shows a diagram depicting the weight loss of exemplary first potting materials in dependence of the operation time of a power module as compared to other materials.
Fig. 3 shows a diagram depicting a thermogravimetric analysis (TGA) of an exemplary first potting material compared to another material.
Fig. 4 shows a flow diagram for illustrating a method for fabricating a semiconductor power module according to the second aspect.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

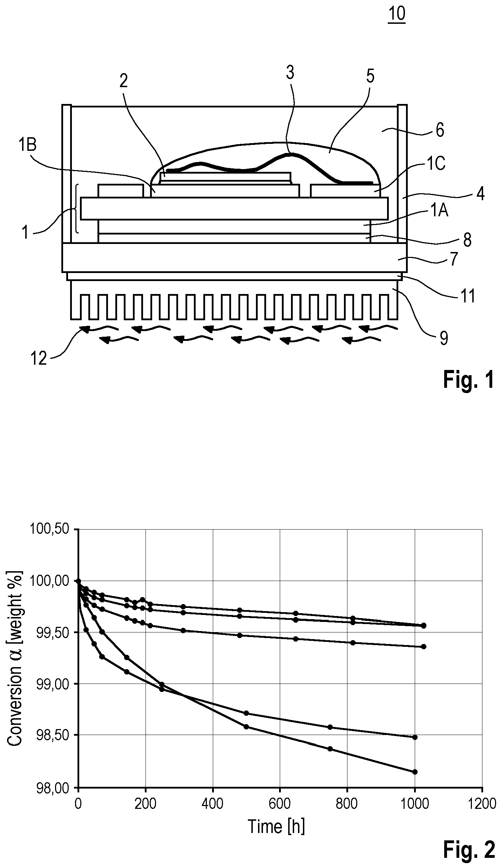

Fig. 1 shows an example of a semiconductor power module.

The semiconductor power module 10 as shown in Fig. 1 comprises an insulating interposer 1 comprising an insulative layer disposed between a lower metal layer 1A, a first upper metal layer 1B and a second upper metal layer 1C, a semiconductor transistor die 2 disposed on the first upper metal layer 1B, an electrical connector 3 connecting the semiconductor transistor die 2 with the second upper metal layer 1C, a housing 4 enclosing the insulating interposer 1 and the semiconductor transistor die 2. The housing 4 can be, for example, a plastic housing. In the embodiment of Fig. 1 the electrical connector 3 is given by a bond wire 3. Instead it is also possible to use a clip or ribbon as electrical connector.

The semiconductor power module of Fig. 1 further comprises a first potting material 5 covering the semiconductor transistor die 2 and the bond wire 3, and a second potting material 6 applied onto the first potting material 5, wherein the first and second potting materials 5 and 6 are different from each other.

The semiconductor power module of Fig. 1 can further comprise a preferably metallic base plate 7 wherein on an upper main surface of the base plate 7 the interposer 1 is mounted by means of a solder joint layer 8 and on a lower main surface of the base plate 7 a heat sink 9 is mounted by means of a thermally conductive and electrically insulating paste 11. A cooling medium 12 is flowing past the heatsink 9.

The first potting material 5 is preferably covered in the form of a coating or glob top on the semiconductor die 2 and the bond wire 3 so that the amount of the first potting material 5 is less or much less than the amount of the second potting material 6. In the embodiment of Fig. 1, the second potting material 6 is applied in such a way onto the first potting material 5 that the complete interior of the housing 4 including hollow spaces between the first potting material 5, the semiconductor die 2, the layers 1C, 1D and the insulating layer 1A of the interposer 1 is filled up by the second potting material 6.

The differences between the first and second potting materials 5 and 6 can be manifold. The first potting material 5 may, for example, comprise a higher temperature stability and a higher thermal conductivity than the second potting material 6 as the first potting material 5 must stand the high temperatures which develop in particular at the hotspots of the semiconductor die 2 and the bond wire 3, i.e. portions with a high current density in operation of the semiconductor power module, and it must effectively conduct the heat to the second potting material 6. On the other hand the second potting material 6 may have a higher creeping ability than the first potting material 5 as for the first potting material 5 creeping ability is not so important in contrast to the second potting material 6 which has to creep through and into narrow spaces which may exist after placing the interposer 1, the semiconductor die 2 and the bond wire 3 in the interior of the housing 4. One other difference between the first and second potting materials 5 and 6 could be that the first potting material 5 may comprise a higher Young's modulus than the second potting material 6. Furthermore the first and second potting materials 5 and 6 could have different amounts of filler particles incorporated therein. The type of filler particles will be mentioned further below. In particular, the first potting material could have a greater amount of filler particles than the second potting material.

There can be only one of the above mentioned differences between the first and second potting materials 5 and 6 or any combination of two or more of these differences.

The embodiment as shown in Fig. 1 is an example of a high temperature application of the first potting material 5. The first potting material 5 is only applied at certain places. The semiconductor die, the electrical connector and possibly also the power terminals are the components with the critical high level of temperature. Other locations in the module assembly have much lower operation temperature so that the application of the high temperature stable material like the first potting material is not necessary there.

Consequently the first potting material 5 may preferably not applied in the same amount as the second potting material. It can, in particular, be applied at the above mentioned components in the form of a glob top or as a coating. The low amount of this material can enable a cost expensive version of the first potting material 5 with high impurity level (low ion content) and high level of reliability and robustness against thermal aging < 2% weight loss in the lifetime of the power module. Then one can choose a relatively cheap material for the second potting material 6 with weight loss > 3,5 % which can be applied in contact with the first potting material 5 to ensure the electrical insulation in all other locations with lower temperature. The second potting material 6 can be, for example, a conventional silicone gel or silicone resin, or, alternatively an epoxy resin or an acrylate, wherein all these can also be filled with filler particles as will be mentioned further below.

As to the material of the first potting material 5 it may, for example, comprise an inorganic filled silicone, namely a silicone filled with particles out of the group containing Al₂O₃, BN, AlN, Si₃N₄, diamond, or any other thermally conductive particles.

The second potting material 6 can also be filled with particles out of the afore-mentioned group of particles. However, in this case the first potting material may have a greater amount of filler particles than the second potting material, in particular in order to yield the specific properties of the first potting material.

It should further be mentioned that power terminals which are not shown in Fig. 1, can also be covered with the first potting material 5. Also here it can be the case that only selective portions, in particular predicted or known hotspots, are covered with the first potting material.

The insulating interposer 1 may comprise one of a direct copper bond (DCB), an active metal braze (AMB) or an insulated metal substrate (IMS).

In the embodiment as shown in Fig. 1 the first potting material completely covers the semiconductor die 2 and the bond wire 3, of course not on their lower surfaces where the semiconductor die 2 is mounted on the first upper layer 1C of the interposer 1 and the bond wire 3 where it is connected with its lower surface with the upper surface of the semiconductor die 2 and the upper surface of the second upper layer 1D of the interposer 1.

It can, however, also be the case that the first potting material 5 only covers selective portions of the semiconductor die 2 or the bond wire 3. For example, it is possible that the first potting material only covers the hotspots, i.e. i.e. portions with a high current density in operation of the semiconductor power module, of the semiconductor die 2 and/or the bond wire 3.

Fig. 2 shows a diagram depicting the weight loss of exemplary first potting materials as compared to other conventional materials.

The two lower curves refer to conventional potting materials based on silicone gel and it can be seen that after 1000 hours of operation time of the power module the weight loss is 1,5% or more. On the other hand the three upper curves refer to one and the same potting material corresponding to the above mentioned first potting materials wherein the curves differ with regard to the operation temperature of the power module. The uppermost curve and the second uppermost curve refer to operation temperatures of 200°C and 250°C and it can be seen that the weight loss after 1000 hours of operation time of the power module is only about 0,4%. Only the lowermost curve of these three curves referring to an operation temperature of 250°C and shows a weight loss after 1000 hours of operation time of the power module of about 0,6%. It can thus be concluded that the potting materials corresponding to the above mentioned first potting materials can be used for operation temperatures up to 300°C operation temperature with less than 2% of weight loss and low level of reduction of the elongation at break.

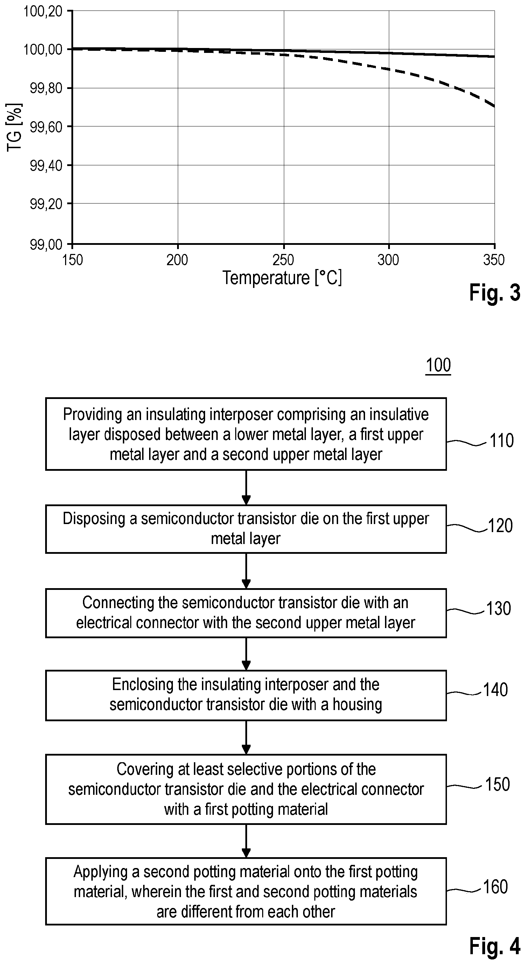

Fig. 3 shows a diagram depicting a thermogravimetric analysis (TGA) of an exemplary first potting material compared to another material.

Thermogravimetric analysis or thermal gravimetric analysis (TGA) is a method of thermal analysis in which changes in physical and chemical properties of materials are being observed as a result of increase in temperature. Both curves shown in Fig. 3 show the weight loss (%) of two materials with respect to the temperature increase. As temperature is increased the weight decreases due to different reactions taking place with increasing the temperature. The lower curve belongs to a standard epoxy material whereas the upper curve belongs to a potting material such as the first potting material of the present disclosure. It can clearly be seen that the potting material of the upper curve shows only a minimal weight loss up to a temperature of 350° whereas the standard epoxy material of the lower curve shows a weight loss of more than 0,2% up to a temperature of 350°C.

Fig. 4 shows a flow diagram for illustrating a method for fabricating a semiconductor power module according to the second aspect.

The method 100 as shown in Fig. 4 comprises providing an insulating interposer comprising an insulative layer disposed between a lower metal layer, a first upper metal layer and a second upper metal layer (110),
disposing a semiconductor transistor die on the first upper metal layer (120),
connecting the semiconductor transistor die with an electrical connector with the second upper metal layer (130), enclosing the insulating interposer and the semiconductor transistor die with a plastic housing (140),
covering at least selective portions of the semiconductor transistor die and the electrical connector with a first potting material (150), and
applying a second potting material onto the first potting material, wherein the first and second potting materials are different from each other (160).

Insofar as the above method is presented as having a specific order of method steps, it should be mentioned that the method is not restricted to this specific order and any other appropriate order of the method steps may be employed by the skilled person.

Employing another order can be particularly relevant for the step of covering at least selective portions of the semiconductor transistor die and the electrical connector with a first potting material. In the order shown above the covering step would be done after disposing the semiconductor transistor die on the interposer, connecting the semiconductor transistor die with an electrical connector with the second upper metal layer, and enclosing the insulating interposer and the semiconductor transistor die with a plastic housing. However, it is also possible to cover the semiconductor die, the electrical connector and possibly also the power terminals with the first potting material before mounting them together. This would have the advantage of greater flexibility and freedom in applying the material to the components and one would save the step of the possibly difficult application of the material in the assembled state of the power module.

### EXAMPLES

In the following specific examples of the present disclosure are described.
Example 1 is a semiconductor power module, comprising:
   an insulating interposer comprising an insulative layer disposed between a lower metal layer, a first upper metal layer and a second upper metal layer;
   a semiconductor transistor die disposed on the first upper metal layer;
   an electrical connector connecting the semiconductor transistor die with the second upper metal layer;
   a housing enclosing the insulating interposer and the semiconductor transistor die;
   a first potting material covering at least selective portions of the semiconductor transistor die (2) and the electrical connector; and
   a second potting material applied onto the first potting material;
   wherein the first and second potting materials are different from each other.
Example 2 is the semiconductor power module according to Example 1, wherein the first potting material completely covers the semiconductor transistor die and the electrical connector.
Example 3 is the semiconductor power module according to Example 1 or 2, wherein the amount of the first potting material is less than the amount of the second potting material.
Example 4 is the semiconductor power module according to any one of the preceding Examples, wherein the first potting material comprises a higher temperature stability than the second potting material.
Example 5 is the semiconductor power module according to any one the preceding Examples, wherein the second potting material comprises a higher creeping ability than the first potting material.
Example 6 is the semiconductor power module according to any one of the preceding Examples, wherein the first potting material comprises a higher thermal conductivity than the second potting material.
Example 7 is the semiconductor power module according to any one of the preceding Examples, wherein the first potting material comprises a higher Young's modulus than the second potting material.
Example 8 is the semiconductor power module according to any one of the preceding Examples, wherein the first potting material comprises an inorganic filled silicone.
Example 9 is the semiconductor power module according to any one of the preceding Examples, wherein one or both of the first and second potting materials are filled with particles out of the group containing Al₂O₃, BN, AlN, Si₃N₄, diamond, or any other thermally conductive particles.
Example 10 is the semiconductor power module according to Example 9, wherein the second potting material comprises a higher amount of particles than the first potting material.
Example 11 is the semiconductor power module according to any one of the preceding Examples, wherein the first potting material is covered only on portions with a high current density in operation of the semiconductor power module.
Example 12 is the semiconductor power module according to any one of the preceding claims, wherein power terminals are also covered at least in part by the first potting material.
Example 13 is the semiconductor power module according to any one of the preceding Examples, wherein the second potting material is based on one or more of a silicone gel, a resin, an epoxy resin, or an acrylate.
Example 14 is the semiconductor power module according to any one of the preceding Examples, wherein the insulating interposer comprises one of a direct copper bond (DCB), an active metal braze (AMB) or an insulated metal substrate (IMS).
Example 15 is a method for fabricating a semiconductor power module, the method comprising
   providing an insulating interposer comprising an insulative layer disposed between a lower metal layer, a first upper metal layer and a second upper metal layer;
   disposing a semiconductor transistor die on the first upper metal layer;
   connecting the semiconductor transistor die with an electrical connector with the second upper metal layer;
   enclosing the insulating interposer and the semiconductor transistor die with a housing;
   covering at least selective portions of the semiconductor transistor die and the electrical connector with a first potting material; and
   applying a second potting material onto the first potting material, wherein the first and second potting materials are different from each other.
Example 16 is the semiconductor power module according to Example 15, wherein the semiconductor transistor die and the electrical connector are completely covered by the first potting material.
Example 17 is the semiconductor power module according to Example 15 or 16, wherein power terminals are also covered by the first potting material.
Example 18 is the semiconductor power module according to any one of Examples 15 to 17, wherein the first and second potting materials are applied by a dispensing process.
Example 19 is the semiconductor power module according to any one of Examples 15 to 17, wherein the first potting material is applied by a compression molding process.

It should further be mentioned that any examples, embodiments, features, comments, or remarks mentioned above in connection with a power module are to be understood as also disclosing a respective method step for providing or fabricating the respective device feature.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor power module (10), comprising:
- an insulating interposer (1) comprising an insulative layer (1A) disposed between a lower metal layer (1B), a first upper metal layer (1C) and a second upper metal layer (1D);
- a semiconductor transistor die (2) disposed on the first upper metal layer (1C);
- an electrical connector (3) connecting the semiconductor transistor die (2) with the second upper metal layer (1D);
- a housing (4) enclosing the insulating interposer (1) and the semiconductor transistor die (2);
- a first potting material (5) covering at least selective portions of the semiconductor transistor die (2) and the electrical connector (3); and
- a second potting material (6) applied onto the first potting material (5);
wherein the first and second potting materials (5, 6) are different from each other.

2. The semiconductor power module (10) according to claim 1, wherein
the first potting material (5) completely covers the semiconductor transistor die (2) and the electrical connector (3).

3. The semiconductor power module (10) according to claim 1 or 2, wherein
the amount of the first potting material (5) is less than the amount of the second potting material (6).

4. The semiconductor power module (10) according to any one of the preceding claims, wherein
the first potting material (5) comprises a higher temperature stability than the second potting material (16).

5. The semiconductor power module (10) according to any one the preceding claims, wherein
the second potting material (6) comprises a higher creeping ability than the first potting material (5).

6. The semiconductor power module (10) according to any one of the preceding claims, wherein
the first potting material (5) comprises a higher thermal conductivity than the second potting material (6).

7. The semiconductor power module (10) according to any one of the preceding claims, wherein
the first potting material (5) comprises a higher Young's modulus than the second potting material (6).

8. The semiconductor power module (10) according to any one of the preceding claims, wherein
the first potting material (5) comprises an inorganic filled silicone.

9. The semiconductor power module (10) according to any one of the preceding claims, wherein
one or both of the first and second potting materials (5, 6) are filled with particles out of the group containing Al₂O₃, BN, AlN, Si₃N₄, diamond, or any other thermally conductive particles.

10. The semiconductor power module (10) according to claim 9, wherein
the second potting material (6) comprises a higher amount of particles than the first potting material (5).

11. The semiconductor power module (10) according to any one of the preceding claims, wherein
the first potting material (5) is covered only on portions with a high current density in operation of the semiconductor power module.

12. The semiconductor power module (10) according to any one of the preceding claims, wherein
power terminals are also covered at least in part by the first potting material (6).

13. The semiconductor power module (10) according to any one of the preceding claims, wherein
the second potting material (6) is based on one or more of a silicone gel, a resin, an epoxy resin, or an acrylate.

14. The semiconductor power module (10) according to any one of the preceding claims, wherein
the insulating interposer (1) comprises one of a direct copper bond (DCB), an active metal braze (AMB) or an insulated metal substrate (IMS).

15. A method (100) for fabricating a semiconductor power module, the method comprising
- providing an insulating interposer comprising an insulative layer disposed between a lower metal layer, a first upper metal layer and a second upper metal layer (110);
- disposing a semiconductor transistor die on the first upper metal layer (120);
- connecting the semiconductor transistor die with a electrical connector with the second upper metal layer (130);
- enclosing the insulating interposer and the semiconductor transistor die with a housing (140);
- covering at least selective portions of the semiconductor transistor die and the electrical connector with a first potting material (150); and
- applying a second potting material onto the first potting material, wherein the first and second potting materials are different from each other (160).

16. The method according to claim 15, wherein
the semiconductor transistor die and the electrical connector are completely covered by the first potting material.

17. The method according to claim 15 or 16, wherein
power terminals are also covered by the first potting material.

18. The method according to any one of claims 15 to 17, wherein
the first and second potting materials are applied by a dispensing process.

19. The method according to any one of claims 15 to 17, wherein
the first potting material is applied by a compression molding process.
